## Europäisches Patentamt
## European Patent Office
## Office européen des brevets

(19)

(11) Veröffentlichungsnummer: **0 109 079**
**B1**

(12) # EUROPÄISCHE PATENTSCHRIFT

(45) Veröffentlichungstag der Patentschrift:
**23.04.86**

(51) Int. Cl.⁴: **G 01 R 31/08,** G 01 R 31/11

(21) Anmeldenummer: **83111338.6**

(22) Anmeldetag: **12.11.83**

(54) Verfahren zur Kabelfehler-Ortung und Vorrichtung zur Ausführung des Verfahrens.

(30) Priorität: **16.11.82 DE 3242412**

(43) Veröffentlichungstag der Anmeldung:
**23.05.84 Patentblatt 84/21**

(45) Bekanntmachung des Hinweises auf die Patenterteilung:
**23.04.86 Patentblatt 86/17**

(84) Benannte Vertragsstaaten:
**AT BE CH DE FR GB IT LI LU NL SE**

(56) Entgegenhaltungen:
**EP - A - 0 010 841**
**DE - A - 2 138 108**
**DE - A - 2 351 318**
**DE - A - 3 010 369**
**DE - B - 2 508 444**

(73) Patentinhaber: **Seba-Dynatronic Mess- und Ortungstechnik GmbH, Industriestrasse 6, D-8601 Baunach (DE)**

(72) Erfinder: **Petsch, Wolfgang, Finkenweg 8, D-8601 Baunach (DE)**
Erfinder: **Allin, Richard, Karl-Krimm-Strasse 15, D-8601 Baunach (DE)**

(74) Vertreter: **Riebling, Günter, Dr. et al, Patentanwälte Dr.-Ing., Dipl.-Ing., Ing.(grad) Günter Riebling Dr.-Ing., Dipl.-Ing. Peter Riebling Rennerle 10 Postfach 3160, D-8990 Lindau (Bodensee) (DE)**

**Beschreibung**

Gegenstand der Erfindung ist ein Verfahren zur Kabelfehlerortung nach dem Oberbegriff des Patentanspruchs 1 und eine Vorrichtung zur Ausführung dieses Verfahrens.

Die Ortung eines Kabelfehlers nach dem Impuls-Echo-Verfahren bereitet vor allem in verzweigten Niederspannungs-Netzen Schwierigkeiten, da die Reflexionsbilder infolge der vielen Muffen, Verzweigungen und Endreflexionen sehr verwirrend aussehen. Ausserdem lässt sich nur sehr schwer und mit grossem Zeitaufwand der Fehler nach Auswertung des Reflexionsbildes in dem verzweigten Leitungsabschnitt lokalisieren. Die Ursache ist u.a. darin zu suchen, dass der Kabelverlauf nicht immer genau bekannt ist und somit eine Kabelsuche mit einer Tonfrequenzanlage durchgeführt werden muss. Hierbei wird die zu suchende Leitung mit einem Tonfrequenzstrom beaufschlagt, wobei um den stromdurchflossenen Leiter ein Magnetfeld entsteht, das mit Hilfe geeigneter Messgeräte (Empfänger und Empfangsspule) in seiner Lage geortet werden kann und somit zur Bestimmung des Leitungsverlaufes führt.

Nach oberirdischer Markierung der unterirdischen Kabeltrasse ist bei verzweigten Kabeln immer noch nicht eindeutig bekannt, in welchem Leitungsabschnitt sich der Fehler befindet.

Während die Messverfahren, Impuls-Echo-Messungen und Tonfrequenz, zur Fehlereingrenzung führten, kommt jetzt zur punktgenauen Ortung als drittes Messverfahren die Stosswellen-Methode zum Einsatz.

Bei diesem bekannten Verfahren erzeugt ein Stosswellen-Generator an der Fehlerstelle energiereiche Überschläge, deren Schallfeld an der Erdoberfläche von der Empfangseinrichtung (Empfänger und Geophon) optisch und akustisch angezeigt wird und somit zur punktgenauen Ortung führt, wobei mit dieser Empfangseinrichtung nochmals die vorher markierte Trasse abgelaufen werden muss, um die Intensität des Schallmaximums feststellen zu können.

Da zu dieser Messmethode der Kabelfehlerortung alle drei Verfahren (Impuls-Echo-Messung, Tonfrequenz und Stosswellen-Methode) nur separat zur Anwendung kommen, ist die Ortung des Kabelfehlers nach dem Stand der Technik eine sehr aufwendige Angelegenheit.

Die vorliegende Erfindung hat sich die Aufgabe gestellt, ein eingangs genanntes Messverfahren wesentlich weniger arbeitsaufwendig zu gestalten.

Zur Lösung der gestellten Aufgabe dienen die im kennzeichnenden Teil des Anspruchs 1 angegebenen technischen Verfahrensschritte.

Wesentliches Merkmal der vorliegenden Erfindung ist nach dem Gegenstand des Anspruchs 1, dass im Verlaufe der Impuls-Echo-Messung gleichzeitig ein Leuchtpunkt auf dem Schirmbild des Impuls-Echo-Messgerätes erzeugt wird, wobei dieser Leuchtpunkt die momentane Lage (Stellung) der tragbaren Sende- und Empfangseinrichtung längs des gemessenen Kabels wiedergibt.

Die Person, welche die tragbare Sende- und Empfangseinrichtung mit sich führt, kann nun mittels Sprechfunk zu dem Ort des vermuteten Fehlers hindirigiert werden, wobei auf dem Schirmbild der durch die erfindungsgemäss vorgeschlagene Anlage erzeugte Leuchtpunkt auf dem Reflexionsdiagramm mitwandert. Es ergibt sich damit eine wesentliche Arbeitsvereinfachung, denn sobald die Sende- und Empfangseinrichtung an der vermuteten Fehlerstelle angekommen ist, wird das Impuls-Echo-Messgerät von dem zu untersuchenden Kabel entfernt und statt dessen ein Stosswellen-Generator angeschlossen. Es werden nun energiereiche Überschläge erzeugt, und die am Ort des vermuteten Fehlers stehende Person empfängt nun mit einem an der Sende- und Empfangseinrichtung angekoppelten Mikrophon und einem darin angeordneten dritten Empfänger die akustisch, oberirdisch zu hörenden Überschläge des unterirdisch verlegten Kabels. Der Fehler ist dann somit sofort gefunden.

Diese schnelle Fehlersuche ist nur deshalb möglich, weil das stationäre Impuls-Echo-Messgerät mit einer besonderen stationären Sende- und Empfangseinrichtung verbunden ist, der eine tragbare Sende- und Empfangseinrichtung zugeordnet ist, die der Leitungssuchende mit sich führt.

Das Impuls-Echo-Messgerät, in einem Kabelmesswagen oder in der einzumessenden Anlage stationiert, wird mit dem fehlerbehafteten Kabel verbunden und eine normale Laufzeitmessung wird dann vorgenommen. Während dieser Messung beginnt ein zweiter Messtechniker mit der Leitungssuche. Die hierbei zur Anwendung kommende Einrichtung besteht aus einem Empfänger und einer kombinierten Empfangs- und Sendespule mit eingebautem Geophon. Diese Einrichtung ist mit einer Elektronik (Sender 2/Empfänger 1) versehen, die das Kabel über die Sendespule mit einer bestimmten Frequenz induktiv besendet und von einem Empfänger E2 im Impuls-Echo-Gerät empfangen wird, der wiederum den ersten Sender S1 aktiviert. Dieser beaufschlagt das Kabel mit einem Signal, welches erneut über die Empfangsspule von dem Empfänger E1 aufgenommen wird.

Die Zeitdifferenz zwischen den gepulsten Signalen S1 und E2 wird mit der halben kabeltypischen Fortpflanzungsgeschwindigkeit multipliziert. Das Ergebnis wird einem Modul zugeführt, das die Aufgabe hat, dem Bediener des Impuls-Echo-Gerätes den Standpunkt des Leitungssuchenden über der Trasse in Form eines Leuchtpunktes auf dem Flexionsbild anzugeben.

Der Leitungssuchende kann jetzt über Sprechfunk oder ähnlichem zum Kabelfehler dirigiert werden, wobei der Leuchtpunkt sich in gleicher Richtung und Geschwindigkeit auf dem Reflexionsbild bewegt wie der Leitungssuchende über der Trasse.

Da gerade in verzweigten Niederspannungsnetzen der tatsächliche Kabelfehler und der angenommene Fehler nicht getrennt auf dem Reflexionsbild auszumachen sind, wird zur Sicherheit das Impuls-Echo-Messgerät gegen einen Stosswellen-Generator ausgetauscht, wobei in diesem Fall der Fehlersuchende bereits seine oberirdische Fehlermarkierungen am Ort des vermuteten Fehlers gesetzt hat und sich direkt über einem dieser Punkte befindet.

Mit dem Stosswellen-Generator wird an der Fehlerstelle, wie bereits beschrieben, ein Überschlag erzeugt und die Intensität über das Geophon an den Empfänger geleitet. Wird kein Überschlagssignal empfangen, befindet sich der Fehlersuchende an der falschen Stelle, kann aber gezielt an der schon vorher markierten Fehlerstelle das Geophon mit Erfolg einsetzen.

Dieses Verfahren bringt weitere erhebliche Erleichterungen und Zeitersparnis bei der Fehlerortung auf dem Fernmeldesektor mit sich, da auf diesem Gebiet wegen der strengen Bestimmungen zur punktgenauen Fehlerortung der Einsatz von Hochspannungsgeräten nicht erlaubt ist. Eine Fehlersuche ist bei niederohmigen Fehlern daher auch ohne das Stosswellen-Ortungsverfahren nach der Erfindung möglich.

Weiterhin erspart man sich auf dem Gebiet der Energieversorgung mit diesem Verfahren eine Punktortung nach der Stosswellen-Methode bei niederohmigen Fehlern.

Beim Einsatz dieses Verfahrens erübrigt sich ausserdem die relativ zeitaufwendige Drall-Methode zur punktegenauen Ortung von Muffen.

Zur Auslese eines Kabels aus einem Kabelbündel kann diese Leuchtpunkt-Methode ebenfalls mit Erfolg eingesetzt werden.

Der Vorteil bei diesem Verfahren liegt darin, dass der Leitungs-/Fehlersuchende in einem einzigen Arbeitsgang zum Ergebnis kommt, während nach bisherigen Methoden mindestens zwei bis drei Arbeitsgänge notwendig waren.

Im folgenden wird die Erfindung anhand von lediglich einen Ausführungsweg darstellenden Zeichnungen näher erläutert. Hierbei gehen aus den Zeichnungen und ihrer Beschreibung weitere erfindungswesentliche Merkmale und Vorteile der Erfindung hervor.

Es zeigen:

Fig. 1a schematisiert den Verlauf eines unterirdisch verlegten Kabelbündels mit seitlich verzweigt ansetzenden Kabeln;

Fig. 1b die graphische Darstellung des Kabels nach Fig. 1a, die sich der Messtechniker im stationären Messwagen aufgrund des Reflexionsdiagramms nach Fig. 1c bei der Anwendung der bisherigen Messverfahren anfertigen würde. Nach der Erfindung ist dies nicht mehr notwendig;

Fig. 1c das Reflexionsdiagramm als Ergebnis von Impuls-Echo-Messungen;

Fig. 2 schematisiert die gezeichnete Darstellung des Verfahrens nach der Erfindung;

Fig. 3 das detaillierte Blockschaltbild der Anordnung nach Fig. 2.

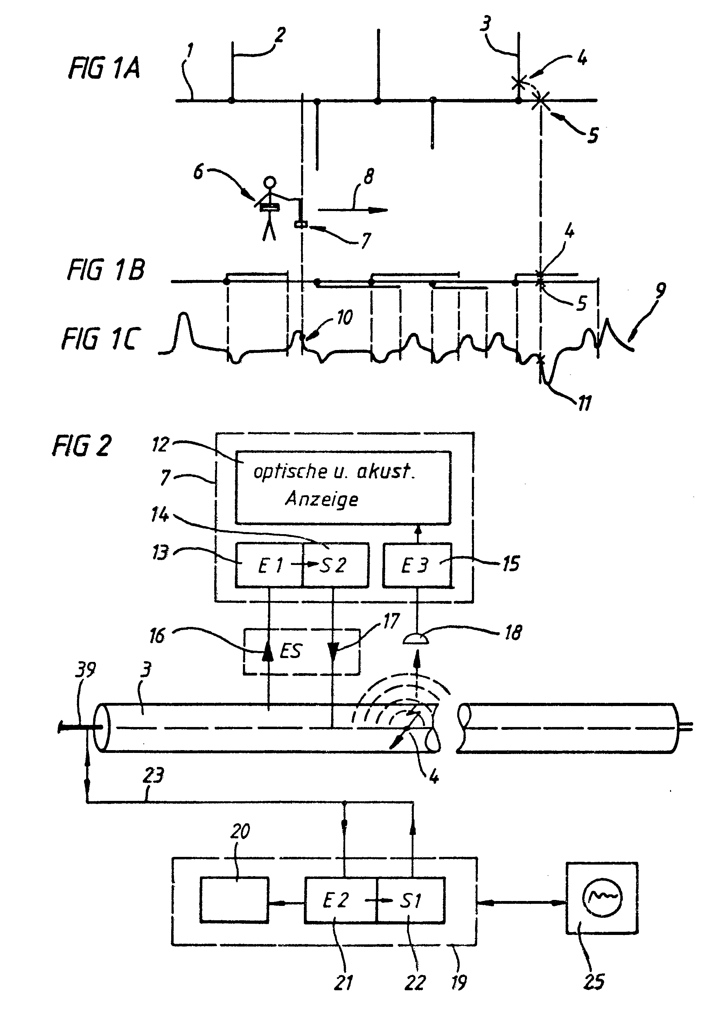

In Fig. 1a ist ein Kabel 1 gezeigt, an dem mehrere Kabel 2, 3 ansetzen. Im Kabel 3 am Punkt 4 sei der Kabelfehler, wobei aufgrund des Impuls-Echo-Diagramms nach Fig. 1c auch am Punkt 5 der Kabelfehler sein könnte.

Das in Fig. 1c dargestellte Schirmbild 9 enthält verschiedene Maxima und Minima, wobei ein Fehler am Ort von Kurven Minima 11 vorliegt. Aufgrund der Auswertung des Schirmbildes 9 und des Wissens, in einem verzweigten Netz zu messen, würde also gemäss Fig. 1b am Punkt 4 oder 5 der Kabelfehler zu vermuten sein.

Während der Durchführung der Messung nach dem Impuls-Echo-Verfahren bewegt sich gleichzeitig ein Leitungssuchender 6 mit einer tragbaren Sende- und Empfangseinrichtung 7 entlang des Kabels 1 in Pfeilrichtung 8.

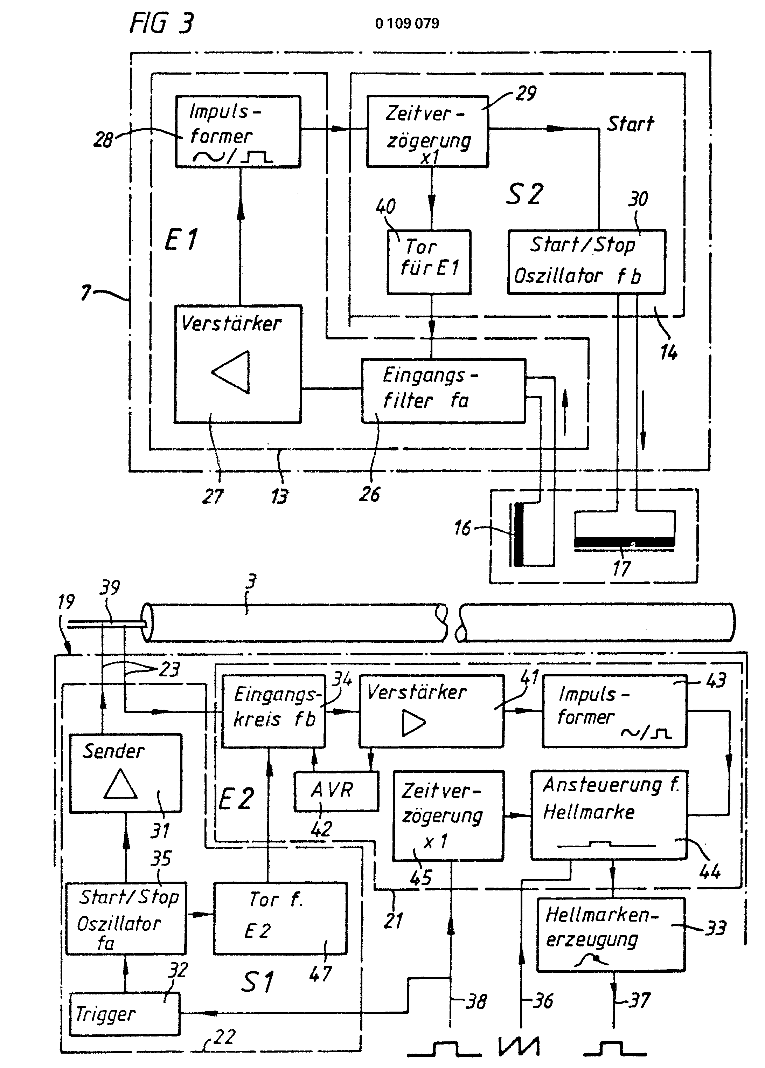

Erfindungsgemäss wird mit der anhand der Fig. 2 und 3 zu beschreibenden Anlage ein Leuchtpunkt 10 auf dem Schirmbild 9 des Reflexionsdiagramms erzeugt, wobei dieser Leuchtpunkt 10 gemäss der vertikalen, gestrichelten Linie genau mit der momentanen Stellung der Sende- und Empfangseinrichtung 7 längs des zu untersuchenden Kabels 1 übereinstimmt.

Aufgrund der Sprechfunkverbindung des Messtechnikers im stationären Messwagen mit dem Leitungssuchenden 6, der sich entlang des unterirdischen Kabels 1 bewegt, ist es möglich, den Leitungssuchenden 6 nun punktgenau zum Ort des vermuteten Fehlers an den Punkten 4 und 5 zu schicken, so dass dieser die vermuteten Fehlerorte sofort durch Markierungsstangen oder ähnliches markieren kann.

Der Messtechniker im stationären Messwagen schaltet nun einen Stosswellen-Generator ein, so dass energiereiche Überschläge am Ort des Kabelfehlers 4 erzeugt werden und der Leitungssuchende 6 mit einem Mikrophon 18 (Fig. 2) und einem zugeordneten Empfänger 15 diese energiereichen Überschläge sofort oberirdisch feststellen kann. Entweder befindet er sich bereits schon über dem Kabelfehler am Punkt 4, oder er befindet sich noch am Punkt 5 und weiss, nachdem er keine Überschläge mit seiner Sende- und Empfangseinrichtung 7 feststellen kann, dass er sich am falschen Punkt befindet, so dass er unmittelbar zum Punkt 4 des wirklichen Kabelfehlers hinübergehen kann.

Die Durchführung des erfindungsgemässen Messverfahrens wird nun anhand der Fig. 2 und 3 näher erläutert.

Ein Impuls-Echo-Gerät 25 mit zugeordnetem Schirmbild, auf dem ein Diagramm gemäss Fig. 1c erzeugt wird, ist erfindungsgemäss mit einer neuartigen Sende- und Empfangseinrichtung 19 gekoppelt.

Diese Sende- und Empfangseinrichtung besteht aus einem ersten Sender 22, der das Kabel über dem Kabelanfang 39 galvanisch mit einer Frequenz $f_a$ besendet, wobei in der Sende- und Empfangseinrichtung ein Empfänger 21 angeordnet ist, der nur selektiv ein gepulstes Signal der Frequenz $f_b$ empfängt.

Dem galvanisch auf das Kabel 3 eingekoppelten Sendesignal der Frequenz $f_a$ ist in der tragbaren Sende- und Empfangseinrichtung 7, welche der Leitungssuchende 6 mit sich führt, ein zweiter Empfänger 13 zugeordnet, der über eine Empfangsspule 16 induktiv das über das Kabel 3 geleitete Sendesignal $f_a$ empfängt, der seinerseits einen zweiten Sender 14 aktiviert (ansteuert), der über eine Sendespule 17 ein gepulstes Sendesignal anderer Frequenz $f_b$ auf das Kabel 3 einkoppelt.

Dieses Sendesignal $f_b$ wird über den am Kabel 3 angeschalteten ersten Empfänger 21 empfangen. Es wird sodann der Laufzeitunterschied zwischen dem abgegebenen Signal fa und dem empfangenen Signal fb gemessen und einem Rechenbaustein 20 eingegeben, der hieraus den Abstand der tragbaren Sende- und Empfangseinrichtung 7 vom Kabelanfang 39 errechnet und als Leuchtpunkt auf dem Schirmbild des Impuls-Echo-Gerätes 25 zur Anzeige bringt.

Die erforderlichen Signale werden hierbei über die Leitung 23 auf das Kabel 3 rückgekoppelt.

Wurde nun gemäss der vorstehenden Beschreibung der Leitungssuchende 6 mit seiner Sende- und Empfangseinrichtung an den vermuteten Ort des Kabelfehlers (Punkt 4) dirigiert, dann wird die stationäre Sende- und Empfangseinrichtung 19 vom Kabel abgekoppelt und statt dessen ein Stosswellen-Generator angekoppelt. Es werden nun energiereiche Überschläge am Punkt 4 des Kabels 3 erzeugt, die aufgrund ihres lauten Knakkens an der Erdoberfläche gehört und mit einem Mikrophon 18 der tragbaren Sende- und Empfangseinrichtung 7 erfasst werden. Dem Mikrophon 18 ist ein dritter Empfänger 15 zugeordnet, der sein Signal an eine optische und akustische Anzeige 12 abgibt, so dass der Leitungssuchende 6 nun unmittelbar durch Beobachtung der Anzeige 12 den Fehler im Kabel 3 am Punkt 4 gefunden hat.

Durch ein externes Triggersignal auf der Leitung 38 wird der Trigger 32 angesteuert, der seinerseits den Start/Stop-Oszillator 35 ansteuert, der mit der Frequenz $f_a$ schwingt. Für die Zeit, in welcher der Oszillator 35 schwingt, ist über die Torschaltung 47 der Eingangskreis 34 des Empfängers 21 gesperrt. Das Signal mit der Frequenz $f_a$, welches der Oszillator 35 erzeugt, wird von dem Sender 31 verstärkt und dem Kabelanfang 39 zugeführt.

Das so auf das Kabel 3 eingespeiste Signal wird von der Empfangsspule 16 der tragbaren Sende- und Empfangseinrichtung 7 erfasst und einem Eingangsfilter 26 zugeführt, der nur für die Frequenz $f_a$ durchlässig ist. Das Ausgangssignal wird einem Verstärker 27 zugeführt, der auf einen Impulsformer wirkt, wo das Sinussignal in ein Rechtecksignal umgewandelt wird. Anschliessend wird dieses Signal um die Zeit X1 verzögert (Zeitverzögerer-Baustein 29), wobei dieses zeitverzögerte Signal einer Torschaltung 40 zugeführt wird, die seinerseits den Eingangsfilter 26 für den zweiten Empfänger 13 sperrt. Das zeitverzögerte Signal am Ausgang des Zeitverzögerer-Bausteins 29 wird gleichzeitig einem Start/Stop-Oszillator 30 zugeführt, der mit der Frequenz $f_b$ auf die Sendespule 17 wirkt. Die Sendespule 17 überträgt dieses Signal induktiv auf das Kabel 3.

Dieses Signal wird wiederum am Kabelanfang 39 über die Leitung 23 dem Eingangskreis 34 des Empfängers 21 zugeführt, wo es anschliessend einen Verstärker 41 durchläuft und einem Impulsformer 43 zugeführt wird. Der Verstärker gibt sein Signal einem AVR-Baustein 42 (automatische Verstärkungs-Regelung) und an den Impulsformer 43 ab. Dieser wandelt das ihm zugeführte Sinussignal in ein Rechtecksignal um und gibt es an die Ansteuerung 44 für die Hellmarke weiter. Die Ansteuerung 44 erzeugt aus den beiden Ausgangssignalen des Impulsformers 43 und der Zeitverzögerung 45 sowie einem extern über die Leitung 36 zugeführten Sägezahnsignal ein Ansteuersignal zur Leuchtpunkterzeugung (Hellmarken-Anzeigung 33). Über die Leitung 37 kann dieses Signal dem Schirmbild des Impuls-Echo-Gerätes 25 zugeführt werden, wo es dann als Leuchtpunkt 10 im Impuls-Echo-Diagramm der Darstellung Fig. 1c erscheint.

Auf diese Weise ist jederzeit der momentane Ort des Leitungssuchenden 6 mit seiner Sende- und Empfangseinrichtung 7 entlang des Kabels 1, 3 zu ermitteln.

Wie vorstehend erläutert wurde, ist das jetzt beschriebene Messverfahren bei niederohmigen Fehlern auch ohne Stosswellen-Generator verwendbar, z.B. in Niederspannungs- und Fernmeldekabeln.

## Patentansprüche

1. Verfahren zur Kabelfehlerortung nach dem Impuls-Echo-Verfahren, bei dem mit einem ersten Sender (22) ein Senderimpuls auf einen fehlerbehafteten Kabelstrang gegeben wird und das Impulsecho mit einem zugeordneten ersten Empfänger (21) empfangen und auf einem Schirmbild (9) dargestellt wird, dadurch gekennzeichnet,

a) dass längs des fehlerbehafteten Kabels (1) eine tragbare Sende- und Empfangseinrichtung (7) bewegt wird,

b) dass in der Sende- und Empfangseinrichtung (7) ein zweiter Empfänger (13) angeordnet ist, der von dem ersten Sender (22) im Impuls-Echo-Gerät (25) getriggert wird,

c) dass dieser zweite Empfänger (13) einen in der Sende- und Empfangseinrichtung (7) angeordneten zweiten Sender (14) triggert,

d) der einen Sendeimpuls auf das fehlerbehaftete Kabel gibt, der von dem zweiten Empfänger (21) im Impuls-Echo-Geräte (25) empfangen wird,

e) dass das Empfangssignal des zweiten Empfängers (21) einen Rechenbaustein (20) zur Erfassung des Abstandes (Laufzeit) der Sende- und Empfangseinrichtung (7) vom Kabelanfang eingegeben wird, und

f) dass das Ausgangssignal des Rechenbausteins (20) auf dem Schirmbild (9) zur Anzeige des momentanen Ortes der Sende- und Empfangseinrichtung (7) längs des Kabels (3) gebracht wird.

2. Verfahren nach Anspruch 1, dadurch gekennzeichnet,

a) dass nach Festlegung der Fehlermarkierungen (4, 5) durch den Leitungssuchenden mit der tragbaren Sende- und Empfangseinrichtung (7) das Impuls-Echo-Gerät (25) durch einen Stosswellen-Generator ersetzt wird,

b) dass mit dem Stosswellen-Generator energiereiche Überschläge im Kabelfehler (4) erzeugt werden, und

c) dass die Überschläge im defekten Kabel (3) am Ort des Kabelfehlers (4) an der Erdoberfläche mit einem Mikrophon (18) und einem dritten Empfänger (15) in der tragbaren Sende- und Empfangseinrichtung (7) erfasst werden. ·

3. Vorrichtung zur Ausführung des Verfahrens nach Anspruch 1, dadurch gekennzeichnet,

a) dass eine im Impuls-Echo-Gerät (25) zusätzlich eingebaute Sende- und Empfangseinrichtung (19) aus dem ersten Sender (22) besteht, der am Kabelanfang (39) ein gepulstes Sendesignal einer ersten Frequenz ($f_a$) einspeist,

b) dass in der tragbaren Sende- und Empfangseinrichtung (7) der zweite Empfänger (13) über eine Empfangsspule (16) diese erste Frequenz ($f_a$) selektiv aufnimmt,

c) dass dieser zweite Empfänger (13) den in der tragbaren Sende- und Empfangseinrichtung (7) angeordneten zweiten Sender (14) ansteuert, der eine zweite Frequenz ($f_b$) erzeugt und über eine Sendespule (17) auf das Kabel (3) einspeist,

d) dass die im Impuls-Echo-Gerät (25) zusätzlich eingebaute Sende- und Empfangseinrichtung den ersten Empfänger (21) aufweist, der selektiv die Frequenz ($f_b$) des zweiten Senders (14) erfasst, und

e) dass die Zeitverschiebung zwischen dem Sendesignal (fa) des ersten Senders (22) und dem Empfangssignal (fb) des ersten Empfängers (21) gemessen wird und hieraus die Laufzeit und damit der Abstand der tragbaren Sende- und Empfangseinrichtung (7) vom Kabelanfang (39) ermittelt wird.

4. Vorrichtung nach Anspruch 3, dadurch gekennzeichnet, dass der Sender (22) in der stationären Sende- und Empfangseinrichtung (19) aus einem Start/Stop-Oszillator (35) besteht, der mit der ersten Frequenz ($f_a$) schwingt und der durch ein externes Triggersignal triggerbar ist, dass ferner für die Zeit, in welcher der Start/Stop-Oszillator (35) schwingt, der Empfänger (21) über eine Torschaltung (47) gesperrt ist.

5. Vorrichtung nach einem der Ansprüche 3 oder 4, dadurch gekennzeichnet, dass das im Empfänger (13) der tragbaren Sende- und Empfangseinrichtung (7) empfangene Signal der ersten Frequenz ($f_a$) über ein selektives Eingangsfilter (26) einem Verstärker (27) zugeführt wird, an dessen Ausgang ein Impulsformer (28) angeschaltet ist, der aus dem Sinussignal ein Rechtecksignal formt, das um eine bestimmte Zeit (X1) von einem Zeitverzögerungs-Baustein (29) verzögert und einer Torschaltung (40) zugeführt wird, welche das Eingangsfilter (26) des Empfängers (13) sperrt, und dass das Ausgangssignal des Zeitverzögerungs-Bausteins (29) einen Start/Stop-Oszillator (30) der zweiten Frequenz (fb) startet, der das Sendesignal (fb) über eine Sendespule (17) induktiv auf das Kabel (3) einspeist.

6. Vorrichtung nach einem der Ansprüche 3 bis 5, dadurch gekennzeichnet, dass der erste Empfänger (21) in der stationären Sende- und Empfangsanlage (19) einen für die zweite Frequenz (fb) selektiven Eingangskreis (34) aufweist, dass dem Eingangskreis (34) ein Verstärker (41) und ein Impulsformer (43) nachgeschaltet sind, und dass der Impulsformer (43) eine Ansteuerung (44) für die Hellmarke ansteuert, die zusammen mit einem extern zugeführten Sägezahnsignal (Leitung 36) ein Ansteuersignal zur Leuchtpunkterzeugung (Leitung 37) erzeugt.

**Claims**

1. A procedure to locate cable faults according to the pulse-echo procedure in which, using a primary transmitter (22), a transmitter impulse is sent to a defective cable line and the pulse echo is received by a co-ordinated primary receiver (21) and displayed on a monitor screen (9), characterized in

(a) that a portable transmission and receiving apparatus (7) is moved along the length of a defective cable (1),

(b) that in the transmission and receiving apparatus (7) a second receiver (13) is fitted which is triggered by the primary transmitter (22) in the pulse-echo equipment (25),

(c) that this second receiver (13) triggers a second transmitter (14) fitted in the transmission and receiving apparatus (7),

(d) which relays a transmitter impulse to the defective cable which is received by the second transmitter (21) in the pulse-echo equipment,

(e) that the received signal of the second receiver (21) is used as a computer base value (20) input to pick up the distance (time delay) between the transmission and receiving apparatus (7) and the start of the cable, and

(f) that the output signal of the computer base value (20) is displayed on a monitor screen (9) as an indication of the current location of the transmission and receiving equipment (7) along the length of the cable (3).

2. Procedure according to Claim 1, characterized in

(a) that subsequent to determination of the fault markings (4, 5) by the search technician with the portable transmission and receiving equipment (7) the pulse-echo apparatus (25) is replaced by a shock-wave generator,

(b) that high-energy impulses are created in cable fault (4) by the shock-wave generator, and

(c) that the impulses in the defective cable (3) in the area of the cable fault (4) are picked up on the surface by a microphone (18) and a third receiver (15) in the transmission and receiving apparatus (7).

3. Apparatus to execute the procedure in accordance with Claim 1, characterized in

(a) that a supplementary transmission and receiving equipment (19) is built into the pulse-echo equipment (25) which, at the start of the cable (39), feeds in a pulsed transmitter signal of the first frequency (fa),

(*b*) that in the portable transmission and receiving equipment (7) the second receiver (13) receives selectively the first frequency (fa) through the receiving coil (16),

(*c*) that this second receiver (13), which controls the second transmitter (14) fitted in the transmission and receiving equipment (7), creates a second frequency (fa) which is fed into the cable (3) through a transmitter coil (17),

(*d*) that the additional transmission and receiving equipment build into the pulse-echo equipment carries the first receiver (21) which selectively picks up the frequency (fb) from the second transmitter (14), and

(*e*) that the time interval between the transmitter signal (fa) of the first transmitter (22) and the receiver signal (fb) of the first receiver (21) is measured from which is determined the time delay and thus the distance of the portable transmission and receiving equipment (7) from the start of the cable (39).

4. Apparatus according to Claim 3, characterized in that the transmitter (22) in the stationary transmission and receiving equipment (19) consists of a start/stop oscillator (35) which oscillates at the first frequency (fa) and which is triggered by an external trigger signal, that further, for the oscillation time of stop/start oscillator, the receiver (21) is shut off by a gate circuit (47).

5. Apparatus according to Claim 3 or 4, characterized in that in receiver (13) the signal at the first frequency (fa) received by the transmission and receiving equipment (7) is led to an amplifier (27) through a selective input filter (26) to the output of which a pulse shaper (28) is connected which converts a sine-wave signal into a square-wave signal which is delayed for a specific time (X1) by a time-delay element (29) and is led to a gate circuit (40) which shuts off the input filter (26) of the receiver (13), and that the output signal from the time-delay element (29) starts a start/stop oscillator (30) at the second frequency (fb) which feeds the transmitter signal (fb) into the cable (3) inductively through a transmitter coil (17).

6. Apparatus according to one of Claims 3 to 5, characterized in that the first receiver (21) in the stationary transmission and receiving equipment (19) carries a selective input circuit (34) for the second frequency (fb), that the input circuit (34) is coupled to an amplifier (41) and a pulse shaper (43), and that the pulse shaper (43) controls an illuminating mark indication controller (44) which, together with an externally fed saw-tooth signal (wiring 36), generates a control signal for the creation of a luminous spot (wiring 37).

## Revendications

1. Procédé pour la localisation des défauts de câble selon le procédé par écho d'impulsion, dans lequel, par un premier émetteur (22), une impulsion d'émission est alimentée à un faisceau défectueux de câbles et l'écho d'impulsion est reçu par le premier récepteur alloué (21) et représenté par une image sur l'écran (9), caractérisé en ce que

a) le long du câble défectueux (1), un dispositif émetteur-récepteur (7) est mis en mouvement,

b) dans le dispositif émetteur-récepteur (7) est disposé un deuxième émetteur (13) qui est déclenché par le premier émetteur (22) dans le dispositif actionné par écho d'impulsion (25),

c) ce deuxième récepteur (13) déclenche un deuxième émetteur (14) disposé dans le dispositif émetteur-récepteur (7),

d) qui alimente au câble défectueux une impulsion d'émission reçue par le deuxième récepteur (21) dans le dispositif actionné par écho d'impulsion (25),

e) le signal reçu du deuxième récepteur (21) est alimenté à une pièce détachée à calculer (20) pour la détection de la distance (durée de fonctionnement) du dispositif émetteur-récepteur (7) à partir du commencement du câble, et en ce que

f) la grandeur de sortie de la pièce détachée à calculer (20) est amenée à indiquer sur l'écran (9) le lieu instantané du dispositif émetteur-récepteur (7) le long du câble (3).

2. Procédé conformément à la revendication 1, caractérisé en ce que

a) après la détermination des repères des défauts (4, 5) par le chercheur de ligne au moyen du dispositif portable émetteur-récepteur (7), le dispositif actionné par écho d'impulsion est remplacé par un générateur d'ondes de choc,

b) par le générateur d'ondes de choc, des amorçages riches en énergie sont produits dans le défaut du câble (4), et en ce que

c) les amorçages dans le câble défectueux (3) sont perçus au lieu du défaut de câble à la surface de la terre au moyen d'un microphone (18) et d'un troisième récepteur (15) dans le dispositif émetteur-récepteur portable (7).

3. Dispositif pour l'exécution du procédé conformément à la revendication 1, caractérisé en ce que

a) un dispositif émetteur-récepteur monté additionnellement dans le dispositif actionné par écho d'impulsion (25) consiste en le premier émetteur (22) alimentant au commencement du câble (39) un signal d'émission à impulsions d'une première fréquence (f$_a$),

b) dans le dispositif émetteur-récepteur portable (7), le deuxième récepteur (13) reçoit sélectivement cette première fréquence par une bobine de réception,

c) ce deuxième récepteur (13) sélectionne le deuxième émetteur (14) disposé dans le dispositif émetteur-récepteur portable, qui produit une deuxième fréquence (f$_b$) et l'alimente au câble (3) par une bobine d'émission (17),

d) le dispositif émetteur-récepteur additionnellement monté dans le dispositif actionné par écho d'impulsion (25) comporte le premier récepteur (21) recevant sélectivement la fréquence (f$_b$) du deuxième émetteur (14), et en ce que

e) le décalage entre le signal d'émission (fa) du premier émetteur (22) et le signal de réception (fb) du premier récepteur (21) est mesuré et que cette valeur mesurée sert à déterminer la distance du dispositif émetteur-récepteur (7) du commencement du câble (39).

4. Dispositif conformément à la revendication 3, caractérisé en ce que l'émetteur (22) dans le dispositif émetteur-récepteur (19) stationnaire consiste en un oscillateur start/stop (35) oscillant avec la première fréquence ($f_a$) et qui peut être déclenché par un signal déclencheur externe et en ce que, en outre, pour le temps pendant lequel l'oscillateur start/stop (35) oscille, le récepteur (21) est bloqué par l'intermédiaire d'un circuit-porte (47).

5. Dispositif conformément à l'une des revendications 3 ou 4, caractérisé en ce que le signal de la première fréquence ($f_a$), reçu dans le récepteur (13) du dispositif émetteur-récepteur portable (7), est amené à un amplificateur (27) par un filtre d'entrée sélectif, à la sortie duquel est connecté un formeur d'impulsions (28) formant, du signal sinusoïdal, un signal rectangulaire, qui est retardé d'un temps déterminé (X1) par un sous-ensemble de temporisation (29) et est amené à un circuit-porte (40) bloquant le filtre d'entrée (26) du récepteur (13), et en ce que le signal de sortie du sous-ensemble de temporisation (29) met en marche un oscillateur start/stop (30) de la deuxième fréquence (fb), qui alimente le signal d'émission (fb) inductivement par une bobine d'émission (17) au câble (3).

6. Dispositif conformément à l'une des revendications 3 à 5, caractérisé en ce que le premier récepteur (21) dans le dispositif émetteur-récepteur stationnaire (19) comporte un circuit d'entrée sélectif pour la deuxième fréquence ($f_b$), en ce que, à la suite du circuit d'entrée, sont intercalés un amplificateur (41) et un formeur d'impulsions (43), et en ce que le formeur d'impulsions (43) déclenche une attaque (44) pour la marque du spot qui, conjointement avec un signal en dent de scie (ligne 36) amené de l'extérieur, produit un signal d'attaque pour la production du point lumineux (ligne 37).

0 109 079

FIG 1A

FIG 1B

FIG 1C

FIG 2

optische u. akust. Anzeige

E1 → S2    E3

ES

E2 → S1

9

FIG 3      0 109 079

11